# EUROPÄISCHE PATENTSCHRIFT

(11) **EP 3 830 905 B1**
(45) Veröffentlichungstag und Bekanntmachung des Hinweises auf die Patenterteilung: **06.05.2026**
(21) Anmeldenummer: 19742609.1
(22) Anmeldetag: 25.07.2019
(51) Int. Cl.: H01R 9/26, H01R 13/627, H01R 13/629, G01R 31/327, H01R 31/08, G01R 1/04

(54) **PRÜFSTECKERBLOCK, PRÜFKLEMMENBLOCK UND VERFAHREN ZUM ENTRIEGELN EINES PRÜFKLEMMENBLOCKS**
TEST PLUG BLOCK, TEST TERMINAL BLOCK AND METHOD OF RELEASING A TEST TERMINAL BLOCK
BLOC DE CONNECTEURS DE CONTRÔLE, BLOC DE BORNES DE CONTRÔLE ET MÉTHODE DE DÉVERROUILLAGE D'UN BLOC DE BORNES DE CONTRÔLE

(30) Priorität: 27.07.2018 BE 201805542
(43) Veröffentlichungstag der Anmeldung: 09.06.2021
(73) Patentinhaber: Phoenix Contact GmbH & Co. KG, 32825 Blomberg (DE)
(72) Erfinder: KLOPPENBURG, Christian, 33142 Büren Wewelsburg (DE)
(74) Vertreter: Gesthuysen Patentanwälte
(86) Internationale Anmeldenummer: PCT/EP2019/069994
(87) Internationale Veröffentlichungsnummer: WO 2020/020988

(56) Entgegenhaltungen:
- DE-A1- 102013 019 066
- DE-U1- 202011 051 798

## Beschreibung

Die Erfindung betrifft einen Prüfsteckerblock zum Aufstecken auf einen Reihenklemmenblock, mit einer Mehrzahl von miteinander verbundenen Prüfsteckern und zwei auf beiden Seiten der Mehrzahl von Prüfsteckern angeordneten Befestigungsteilen, die über ein Griffstück miteinander verbunden sind, wobei die Befestigungsteile jeweils ein Gehäuse und einen Einsteckabschnitt aufweisen, der in einen Aufnahmeabschnitt einsteckbar ist, wobei der Aufnahmeabschnitt im Klemmengehäuse eine Befestigungsklemme des Reihenklemmenblocks ausgebildet ist.

Die Erfindung betrifft auch ein Verfahren zum Entriegeln eines Prüfklemmenblocks.

Darüber hinaus betrifft die Erfindung einen Prüfklemmenblock bestehend aus einem Reihenklemmenblock und einem auf den reinen Reihenklemmenblock aufsteckbaren Prüfsteckerblock, wobei der Reihenklemmenblock eine Mehrzahl von nebeneinander angeordneten Reihenklemmen und auf beiden Seiten der Mehrzahl von Reihenklemmen je eine Befestigungsklemme aufweist, wobei der Prüfsteckerblock eine Mehrzahl von miteinander verbundenen Prüfsteckern und auf beiden Seiten der Mehrzahl von Prüfsteckern je ein Befestigungsteil aufweist, wobei die beiden Befestigungsteile über ein Griffstück miteinander verbunden sind, wobei die Befestigungsteile jeweils ein Gehäuse und einen Einsteckabschnitt aufweisen, der in einen Aufnahmeabschnitt einsteckbar ist, wobei der Aufnahmeabschnitt im Klemmengehäuse einer Befestigungsklemme des Reihenklemmenblocks ausgebildet ist. Elektrische Reihenklemmen sind seit Jahrzehnten bekannt und werden millionenfach bei der Verdrahtung elektrischer Anlagen und Geräte verwendet. Die Klemmen werden meist auf Tragschienen aufgerastet, welche ihrerseits häufig in einer Mehrzahl in einem Schaltschrank angeordnet sind. In der Schalt-, Mess- und Regeltechnik sind Durchgangsklemmen mit Trennmöglichkeiten der Standard. Die bei derartigen Durchgangsklemmen durch die Ausbildung einer Trennstelle im Strombalken realisierte Trennmöglichkeit ermöglicht es dabei, unterschiedliche Stecker mit unterschiedlichen Funktionen in das Klemmengehäuse der Reihenklemme einzustecken, die dann an der Trennstelle den Strombalken kontaktieren. Als Stecker können dabei neben einfachen Trennsteckern oder Durchgangsverbindern insbesondere auch Prüf- oder Teststecker verwendet werden, die spezielle Bauelemente aufweisen können und ein Überprüfen der ordnungsgemäßen Funktion des an die Reihenklemme angeschlossenen Stromkreises ermöglichen.

Elektrische Reihenklemmen, die in der Regel scheibenförmig ausgebildet sind, werden häufig mit mehreren anderen elektrischen Reihenklemmen zu einem Reihenklemmenblock zusammengesteckt und auf eine Tragschiene aufgerastet oder in einem Wandabschnitt, beispielsweise eines Schaltschranks, montiert. Entsprechend werden auch die einzelnen Prüfstecker, die in ihrer Breite in der Regel der Breite der Reihenklemmen entsprechen, zu einem Prüfsteckerblock verbunden und gemeinsam auf einen korrespondierenden Reihenklemmenblock aufgesetzt. Hierbei besteht die Anforderung, dass die Anzahl der miteinander verbundenen Reihenklemmen sowie die Anzahl der miteinander zu einem Prüfsteckerblock zusammengefassten Prüfstecker frei wählbar ist. Gleichzeitig sollen jedoch die zu einem Prüfsteckerblock zusammengefassten Prüfstecker möglichst einfach gemeinsam betätigt, d. h. gemeinsam auf den Reihenklemmenblock aufgesteckt werden können.

Um beim Einstecken des Prüfsteckers in die Prüföffnung definierte Kontaktzustände zu gewährleisten, sind bei der aus der DE 10 2006 052 894 A1 bekannten elektrischen Reihenklemme die Strombalken so ausgebildet, dass sie zwei Kontaktbereiche bilden, die in Aufsteckrichtung eines Prüfsteckers hintereinander angeordnet sind. Bei den bekannten Reihenklemmen ist somit die von den einen Endbereichen der Stromschienen gebildete Trennstelle zweistufig ausgebildet. Durch die Ausbildung eines definierten zweiten Kontaktbereichs, der in Einführrichtung des Kontaktsteckers vor dem ersten Kontaktbereich angeordnet ist, ist gewährleistet, dass es beim Einführen des Kontaktsteckers zunächst zu einer sicheren elektrischen Verbindung zwischen dem Kontaktstecker und den beiden Strombalken kommt, bevor der erste Kontaktbereich beim weiteren Einführen des Kontaktsteckes geöffnet wird, wodurch die beiden Strombalken dann elektrisch voneinander getrennt werden. Bei den zuvor beschriebenen Reihenklemmen bzw. Prüfklemmenblöcken kontaktieren die beiden Strombalken einander, so dass die Leiteranschlusselemente elektrisch leitend miteinander verbunden sind, wenn kein Stecker in die Reihenklemme eingesteckt ist. Ist dagegen ein Stecker (vollständig) in die Reihenklemme eingesteckt, so ist der Kontaktbereich aufgetrennt, so dass auch die Leiteranschlusselemente elektrisch voneinander getrennt sind.

Häufig weisen die einzelnen Prüfstecker des Prüfsteckerblocks unterschiedlich lange Kontaktstecker auf. Beim Aufstecken des Prüfsteckerblocks tauchen dann zunächst die längeren Kontaktstecker einzelner Prüfstecker in die korrespondierenden Öffnungen im Klemmengehäuse der Reihenklemmen ein und kontaktieren dort den in Aufsteckrichtung des Prüfsteckers ersten, voreilenden Kontaktbereich der beiden Strombalken. Wird der Prüfsteckerblock weiter auf den Reihenklemmenblock aufgesteckt, so tauchen die längeren Kontaktstecker in den zweiten Kontaktbereich ein, wodurch dieser Kontaktbereich geöffnet wird, sodass die elektrisch leitende Verbindung zwischen den beiden Strombalken - und damit auch zwischen den beiden mit den Strombalken verbundenen Leiteranschlusselementen - unterbrochen wird. Sind die Kontaktstecker elektrisch leitend, so wird dadurch die Stromführung über den Prüfstecker umgeleitet. Wird der Prüfsteckerblock weiter auf den Reihenklemmenblock aufgesteckt, so kontaktieren als nächstes die kürzeren Kontaktstecker zunächst entsprechend den voreilenden Kontaktbereich in den Reihenklemmen, bevor auch die kürzeren Kontaktstecker den zweiten Kontaktbereich öffnen und dadurch auch die Stromführung dieser Reihenklemmen unterbrochen und gegebenenfalls über die Prüfstecker umgeleitet wird.

Beim Herausziehen des Prüfsteckerblocks aus dem Reihenklemmenblock ist es bei vielen Anwendungsfällen erforderlich oder zumindest gewünscht, dass die längeren Kontaktstecker den Kontaktbereich der zugeordneten Reihenklemmen noch auftrennen, während die kürzeren Kontaktstecker schon aus dem zweiten Kontaktbereich der zugeordneten Reihenklemmen herausgezogen sind, sodass sich die beiden Strombalken der entsprechenden Reihenklemme wieder kontaktieren, wodurch die Stromführung über die Reihenklemme erfolgt. Hierbei besteht bei den bekannten Prüfklemmenblöcken jedoch die Gefahr, dass durch ein zu schnelles oder ungleichmäßiges Herausziehen des Prüfsteckerblockes aus dem Reihenklemmenblock die zuvor beschriebene Abfolge, wonach die Kontaktbereiche einiger Reihenklemmen durch die längeren Kontaktstecker noch geöffnet sind, während über andere Reihenklemmen, denen Prüfstecker mit kürzeren Kontaktsteckern zugeordnet sind, bereits ein Stromübergang erfolgt, nicht sicher oder einwandfrei gewährleistet ist. Hierdurch kann sich ein instabiler bzw. undefinierter elektronischer Zustand einzelner Reihenklemmen des Reihenklemmenblocks ergeben.

Aus der DE 10 2013 019 066 A1 ist es bekannt, zur Gewährleistung von einem zweistufigen Herausziehen des Prüfsteckerblockes aus einem Reihenklemmenblock mindestens zwei Rastelemente vorzusehen, die eine erste und eine zweite Rastposition des Prüfsteckerblocks festlegen, wobei die einzelnen Rastpositionen durch das Verschieben eines Entriegelungselementes einzeln gelöst werden können. Dabei ist das Entriegelungselement derart mit dem Griffstück verbunden, dass eine Drehung des Griffstückes eine geradlinige Bewegung des Entriegelungselementes bewirkt. Zur vollständigen Entriegelung des Prüfsteckerblocks wird das Griffstück zunächst um einen ersten Winkel α, dann um zweiten Winkel β und anschließend zurück in die Grundposition gedreht.

Die Druckschrift DE 20 2011 051798 U1 betrifft einen Prüfsteckerblock zum Aufstecken auf einen Reihenklemmblock mit einer Mehrzahl von miteinander verbundenen Prüfsteckern und zwei auf beiden Seiten der Mehrzahl von Prüfsteckern angeordneten Befestigungsteilen, die über ein Griffstück miteinander verbunden sind. Zudem weisen die Befestigungsteile jeweils einen Einsteckabschnitt auf, der in einen Aufnahmebereich eines reinen Klemmenblocks eingesteckt werden kann.

Der vorliegenden Erfindung liegt ausgehend von diesem Stand der Technik die Aufgabe zugrunde, einen Prüfsteckerblock, einen Prüfklemmenblock und ein Verfahren zum Entriegeln eines Prüfklemmenblocks anzugeben, der ein besonders einfaches und komfortables Handling für den Monteur sowohl beim Einstecken als auch beim Entriegeln bzw. Herausziehen des Prüfsteckerblocks aus einem Reihenklemmenblock gewährleistet.

Diese Aufgabe wird erfindungsgemäß durch die Merkmale der unabhängigen Patentansprüche 1 und 15 gelöst, dass im Einsteckabschnitt mindestens eines Befestigungsteils ein Verriegelungselement angeordnet ist, das durch eine Drehbewegung des Griffstücks von einer Grundposition in eine Entriegelungsposition verbringbar ist, und das also zwischen zwei Positionen, nämlich der Grundposition und der Entriegelungsposition verstellbar ist.

Das Verriegelungselement weist ein erstes Verbindungselement in Form eines Verriegelungshakens oder eines Verriegelungsvorsprungs auf, wobei das erste Verbindungselement mit einem korrespondierenden zweiten Verbindungselement in Form eines Verriegelungsvorsprungs oder eines Verriegelungshakens im Klemmengehäuse der mindestens einen Befestigungsklemme zusammen eine erste Verriegelungsposition festlegt. Außerdem weist das Verriegelungselement wenigstens eine Anschlagfläche auf, wobei die Anschlagfläche zusammen mit einer Gegenanschlagfläche im Klemmengehäuse der mindestens einen Befestigungsklemme in der Entriegelungsposition des Verriegelungselementes ein Herausziehen des Prüfsteckerblocks verhindert.

Grundsätzlich kann der Einsteckabschnitt einstückig mit dem Gehäuse des Befestigungsteils ausgestaltet sein oder der Einsteckabschnitt kann als separates Element mit dem Gehäuse mittelbar oder unmittelbar verbunden sein.

Erfindungsgemäß wurde erkannt, dass ein mehrstufiges Herausziehen des Prüfsteckerblocks aus einem Reihenklemmenblock besonders einfach dadurch realisiert werden kann, dass das Verriegelungselement zwischen zwei Positionen, nämlich der Grundposition und der Entriegelungsposition, verstellbar ist, dass ein erster Verriegelungszustand in der Grundposition realisiert wird und dass ein zweiter Verriegelungszustand in der Entriegelungsposition realisiert wird. Dabei werden im Rahmen der vorliegenden Erfindung die Grundposition und die Entriegelungsposition durch die Stellung des Verriegelungselementes definiert.

In vorteilhafter Weise wird eine Entriegelung des zweiten Verriegelungszustandes, der durch den Anschlag der Anschlagfläche an der Gegenanschlagfläche festgelegt ist, wobei der Prüfsteckerblock bereits um eine definierte Strecke aus dem Reihenklemmenblock herausgezogen ist, dadurch besonders einfach gelöst, dass das Verriegelungselement wieder in die Grundposition verbracht wird. Dies kann besonders dadurch passieren, dass die auf das Griffstück wirkende Kraft gelöst wird, alternativ kann das Griffstück auch aktiv zurückgedreht werden.

Zur Übertragung der Drehbewegung des Griffstückes auf das Verriegelungselement ist das Verriegelungselement vorzugsweise mittelbar, d.h. über wenigstens ein weiteres Übertragungselement mit dem Griffstück verbunden.

Das Handling des Prüfsteckerblocks insbesondere beim Entriegeln und Herausziehen aus einem Reihenklemmenblock ist für den Monteur damit besonders angenehm und kann problemlos auch einhändig erfolgen.

Vorzugsweise weist das Verriegelungselement wenigstens eine weitere Anschlagfläche auf, die zusammen mit einer weiteren Gegenanschlagfläche im Klemmengehäuse der Befestigungsklemme gewährleistet, dass die Bewegung des Verriegelungselementes nicht über die Grundposition hinausgeht. Dies ist insbesondere dann relevant, wenn das Verriegelungselement von der zweiten Verriegelungsposition zurück in die Grundposition verbracht wird. Diese Ausgestaltung weist weiterhin den Vorteil auf, dass ein ungewolltes Verkippen des Verriegelungselementes, das ein Verkanten des Prüfsteckerblocks zur Folge haben könnte, verhindert werden kann. Gemäß einer besonders einfachen Ausgestaltung wird die weitere Gegenanschlagfläche durch das zweite Verbindungselement realisiert.

Gemäß einer nächsten Ausgestaltung weist das Verriegelungselement an der dem Gehäuse abgewandten Seite einen Führungsvorsprung auf, wobei weiterhin der Einsteckabschnitt eine Führungsfläche aufweist, wobei der Führungsvorsprung bewegbar in der Führungsfläche angeordnet ist, sodass die Führungsfläche die Bewegung des Verriegelungselementes auf den Bereich zwischen der Grundposition und der Entriegelungsposition begrenzt und/oder das Verriegelungselement mittels des Führungsvorsprungs und der Führungsfläche in Position gehalten wird. Das Vorhandensein einer solchen Führungsfläche gewährleistet ebenfalls, dass das Verriegelungselement nicht über die Grundposition bzw. über die Entriegelungsposition hinaus bewegbar ist. Auch diese Ausgestaltung weist damit den Vorteil auf, dass ein ungewolltes Verkanten verhindert werden kann. Weiterhin verhindert diese Ausgestaltung eine Bewegung des Verriegelungselements in Richtung der Prüfstecker. Gemäß einer Ausgestaltung ist die Führungsfläche als Nut, die mit dem Führungsvorsprung in Eingriff steht.

Gemäß einer nächsten vorteilhaften Ausgestaltung ist im Gehäuse des mindestens einen Befestigungsteils ein Hebelelement angeordnet, wobei das Hebelelement mit dem Verriegelungselement verbunden ist und wobei das Verriegelungselement durch eine Drehbewegung des Griffstücks mittels des Hebelelementes von der Grundposition in die Entriegelungsposition verbringbar ist. Diese Ausgestaltung weist den Vorteil auf, dass durch den Einsatz des Hebelelementes weniger Kraft zur Positionierung des Verriegelungselementes aufgewendet werden muss.

Gemäß einer Ausgestaltung sind das Hebelelement und das Verriegelungselement einstückig ausgestaltet.

Besonders bevorzugt sind das Hebelelement und das Verriegelungselement drehbar zueinander angeordnet, wobei das Hebelelement ein Führungselement aufweist, wobei das Verriegelungselement bei einer Bewegung des Hebelelementes durch Drehung des Griffstückes durch das Führungselement von der Grundposition in die Entriegelungsposition verbringbar ist. Gemäß dieser Ausgestaltung können das Hebelelement und das Verriegelungselement grundsätzlich auch unabhängig voneinander bewegt werden. Das Führungselement gewährleistet jedoch, dass eine Bewegung des Hebelementes durch Drehung des Griffstückes unmittelbar derart auf das Verriegelungselement übertragen wird, dass dieses von der Grundposition in die Entriegelungsposition verbracht wird. Besonders bevorzugt ist das Führungselement gleichzeitig derart ausgestaltet und angeordnet, dass es ebenfalls die Bewegung des Verriegelungselementes zurück in die Grundposition lenkt und/oder das Verriegelungselement in der Grundposition stabilisiert. Gemäß einer besonders einfachen Ausgestaltung ist das Führungselement als Anschlag zwischen dem Hebelelement und dem Verriegelungselement ausgestaltet.

Gemäß einer nächsten bevorzugten Ausgestaltung weist das Hebelelement einen rotationssymmetrischen Aufnahmebereich auf, wobei das Verriegelungselement einen rotationssymmetrischen Anbindungsbereich aufweist, der in dem Aufnahmebereich des Hebelelementes angeordnet ist, wobei der Anbindungsbereich des Verriegelungselementes in dem Aufnahmebereich des Hebelelementes vorzugsweise mittels wenigstens einer Rastnase gehalten wird. Diese Ausgestaltung der Verbindung des Hebelelementes mit dem Verriegelungselement weist den Vorteil auf, dass ein besonders großer Spielraum einer unabhängigen Bewegung des Verriegelungselements gegeben ist. Besonders bevorzugt ist der Anbindungsbereich des Verriegelungselementes derart in dem Aufnahmebereich des Hebelelementes angeordnet, dass eine gemeinsame Rotationsachse vorhanden ist.

Eine besonders platzsparende Anordnung kann dadurch realisiert werden, dass das Hebelement derart ausgestaltet und angeordnet ist, dass eine Bewegung des Hebelelementes durch das Griffstück eine Rotation des Aufnahmebereichs bewirkt.

Weiterhin von Vorteil ist es, wenn ein Federelement zwischen dem Verriegelungselement und dem Hebelelement derart angeordnet ist, dass das Verriegelungselement durch die Federkraft in die Grundposition verbracht wird, wenn das Griffstück nicht betätigt ist und/oder der Prüfsteckerblock voll eingesteckt ist, sodass das Verriegelungselement in der ersten Verriegelungsposition angeordnet ist. Insbesondere kann dadurch gewährleistet werden, dass das Verriegelungselement auch nach Krafteinwirkung auf das Griffstück stets in die Grundposition zurückgebracht wird. Grundsätzlich wird in vorteilhafter Weise durch ein solches Federelement ebenfalls gewährleistet, dass das Verriegelungselement in Bezug auf das Hebelelement in einer stabilen Position gehalten wird. Ein solches Federelement kann beispielsweise als Druckfeder oder als Zugfeder ausgestaltet sein.

Gemäß einer nächsten Ausgestaltung sind das Verriegelungselement und das Hebelelement derart miteinander verbunden, dass das Verriegelungselement einen Bewegungsspielraum aufweist, sodass beim Einsteckvorgang des Prüfsteckerblocks eine Bewegung des Verriegelungselementes nicht auf das Hebelelement übertragen wird. In vorteilhafter Weise kann so einerseits realisiert werden, dass das Verriegelungselement beim Einsteckvorgang automatisch, d. h. ohne eine manuelle Drehung des Griffstückes, beispielsweise durch das Vorhandensein von Anlaufschrägen in eine Verriegelungsposition verbracht wird. Gleichzeitig weist diese Ausgestaltung den Vorteil auf, dass während des Einsteckens des Prüfsteckerblockes kein unangenehmes Verdrehen des Griffstückes passiert.

Von Vorteil ist es weiterhin, wenn der Aufnahmebereich des Hebelelementes wenigstens ein Begrenzungselement aufweist, wobei das Begrenzungselement die Bewegung des Verriegelungselementes während des Einsteckvorgangs begrenzt. Gemäß einer besonders einfachen Ausgestaltung ist das Begrenzungselement als Anschlagfläche ausgestaltet.

Besonders bevorzugt ist es, wenn das Verriegelungselement ein erstes Lenkungselement aufweist, das zusammen mit einem zweiten Lenkungselement im Klemmengehäuse der mindestens einen Befestigungsklemme das Verriegelungselement beim Einsteckvorgang in die erste Verriegelungsposition führt. Vorzugsweise sind das erste Lenkungselement und das zweite Lenkungselement als Anlaufschrägen ausgestaltet. Gemäß einer Ausgestaltung ist das zweite, im Klemmengehäuse angeordnete Verbindungselement gleichzeitig als zweites Lenkungselement ausgestaltet. Vorzugsweise ist dazu eine Seite des als Verriegelungsvorsprung oder als Verriegelungshaken ausgestalteten zweiten Verbindungselementes als Anlaufschräge ausgebildet.

Gemäß einer nächsten Ausgestaltung sind das erste Verbindungselement und die Anschlagfläche des Verriegelungselementes in Längsrichtung und/oder quer zur Längsrichtung des Verriegelungselementes versetzt zueinander angeordnet.

Gemäß einer nächsten Ausgestaltung ist im Gehäuse des mindestens einen Befestigungsteils mindestens ein Federelement derart angeordnet, dass das Hebelelement in seine Grundposition verbracht wird, wenn das Griffstück nicht betätigt ist. Dabei entspricht die Grundposition des Hebelelementes der Position, in der auch das Verriegelungselement in der Grundposition angeordnet ist. Besonders bevorzugt ist es, wenn mindestens zwei Federelemente vorhanden sind, die in Längsrichtung hintereinander an dem Hebelelement angreifen. Auf diese Weise kann ein Verkanten des Hebelelementes auf besonders einfache Weise vermieden werden. Das Federelement kann beispielsweise als Druckfeder oder als Zugfeder oder als Bandfeder ausgestaltet sein.

Eine besonders einfache Möglichkeit zur Übertragung der Rotationsbewegung des Griffstückes in eine Bewegung des Hebelelementes bzw. des Verriegelungselementes, ist dadurch gegeben, dass das Griffstück vorzugsweise über wenigstens ein Zahnrad mit dem Hebelelement verbunden ist, wobei das wenigstens eine Zahnrad mit einer Seite des Hebelementes in Eingriff steht. Dazu weist das Hebelelement vorzugsweise an der einen Seite ebenfalls eine Mehrzahl von Zähnen auf, die mit den Zähnen des wenigstens einen Zahnrades in Wirkzusammenhang stehen.

Gemäß einer zweiten Lehre der vorliegenden Erfindung wird die eingangs genannte Aufgabe durch einen eingangs beschriebenen Prüfklemmenblock dadurch gelöst, dass im Einsteckabschnitt mindestens eines Befestigungsteils ein Verriegelungselement angeordnet ist, dass das Verriegelungselement durch eine Drehbewegung des Griffstücks von einer Grundposition in eine Entriegelungsposition verbringbar ist, dass das Verriegelungselement ein erstes Verbindungselement in Form eines Verriegelungshakens oder eines Verriegelungsvorsprungs aufweist, das im Klemmengehäuse der mindestens einen Befestigungsklemme ein korrespondierendes zweites Verbindungselement in Form eines Verriegelungsvorsprungs oder eines Verriegelungshakens angeordnet ist, dass das erste Verbindungselement mit dem korrespondierenden zweiten Verbindungselement zusammen eine erste Verriegelungsposition festlegt, dass das Verriegelungselement wenigstens eine Anschlagfläche aufweist, dass das Klemmengehäuse der Befestigungsklemme eine Gegenanschlagfläche aufweist und dass die Anschlagfläche zusammen mit der Gegenanschlagfläche in der Entriegelungsposition des Verriegelungselementes ein Herausziehen des Prüfsteckerblocks verhindert.

Erfindungsgemäß ist der Prüfsteckerblock des Prüfklemmenblocks nach einer der zuvor beschriebenen Ausgestaltungen ausgebildet. Es versteht sich, dass je nach Ausgestaltung des Prüfsteckerblockes auch der Reihenklemmenblock zur Gewährleistung der entsprechenden Vorteile korrespondierend ausgebildet ist.

Erfindungsgemäß ist ein Verfahren zum entriegeln eines Prüfklemmenblocks gemäß dem unabhängigen Anspruch 15 vorgesehen, wobei der Prüfklemmenblock derart ausgestaltet ist, dass eine vollständige Entriegelung des eingesteckten Prüfsteckerblocks durch folgende Bewegungsabfolge erfolgt: Verbringen des Verriegelungselementes von der Grundposition in die Entriegelungsposition durch Drehen des Griffstückes, Herausziehen des Prüfsteckerblocks bis zum Anschlag der Anschlagfläche an die Gegenanschlagfläche (zweite Verriegelungsposition), Verbringen des Verriegelungselementes von der Entriegelungsposition in die Grundposition, Herausziehen des Prüfsteckerblocks. Auf besonders einfache Weise kann insofern der Prüfsteckerblock kontrolliert in zwei Stufen aus dem Reihenklemmenblock herausgezogen werden.

Im Einzelnen gibt es nun eine Vielzahl von Möglichkeiten, den erfindungsgemäßen Prüfsteckerblock und den erfindungsgemäßen Prüfklemmenblock auszugestalten und weiterzubilden. Dazu wird verwiesen sowohl auf die einzelnen Patentansprüche als auch auf die nachfolgende Beschreibung eines bevorzugten Ausführungsbeispiels in Verbindung mit der Zeichnung. In der Zeichnung zeigen:
- Fig. 1: ein Ausführungsbeispiel eines Prüfsteckerblocks und eines Reihenklemmenblocks,
- Fig. 2: ein Ausführungsbeispiel eines Befestigungsteils in voll eingestecktem Zustand,
- Fig. 3.1: ein Ausführungsbeispiel eines Befestigungsteils des Prüfsteckerblocks mit Griffstück,
- Fig. 3.2: ein Ausführungsbeispiel eines Befestigungsteils des Prüfsteckerblocks ohne Griffstück,
- Fig. 4: ein Ausführungsbeispiel eines Befestigungsteils des Prüfsteckerblocks,
- Fig. 5: ein Ausführungsbeispiel eines Verriegelungselementes in der Grundposition im ersten Verriegelungszustand,
- Fig. 6: ein Ausführungsbeispiel eines Verriegelungselementes in der Entriegelungsposition im gelösten Zustand,
- Fig. 7: ein Ausführungsbeispiel eines Verriegelungselementes in der Entriegelungsposition im zweiten Verriegelungszustand,
- Fig. 8: ein Ausführungsbeispiel eines Verriegelungselementes in der Grundposition, die keinen Verriegelungszustand realisiert,
- Fig. 9: die Verbindung von einem Hebelelement mit einem Verriegelungselement.

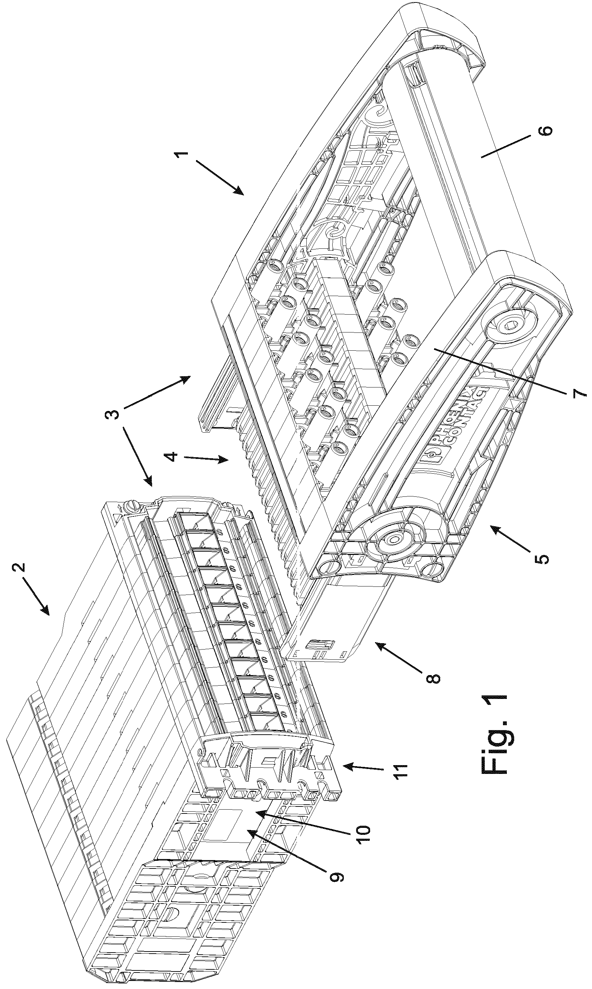

Fig. 1 zeigt in perspektivischer Darstellung die Kombination aus einem Prüfsteckerblock 1 und einem Reihenklemmenblock 2, die zusammen einen Prüfklemmenblock 3 bilden. Der Prüfsteckerblock 1 ist ausgestaltet zum Aufstecken auf den Reihenklemmenblock 2. Er weist eine Mehrzahl von miteinander verbundenen Prüfsteckern 4 und zwei auf beiden Seiten der Mehrzahl von Prüfsteckern 4 angeordnete Befestigungsteile 5 auf, wobei die Befestigungsteile 5 über ein Griffstück 6 miteinander verbunden sind. Die Befestigungsteile 5 weisen jeweils ein Gehäuse 7 und einen Einsteckabschnitt 8 auf, wobei der Einsteckabschnitt 8 in einen Aufnahmeabschnitt 9 im Klemmengehäuse 10 einer Befestigungsklemme 11 des Reihenklemmenblockes 2 einsteckbar ist.

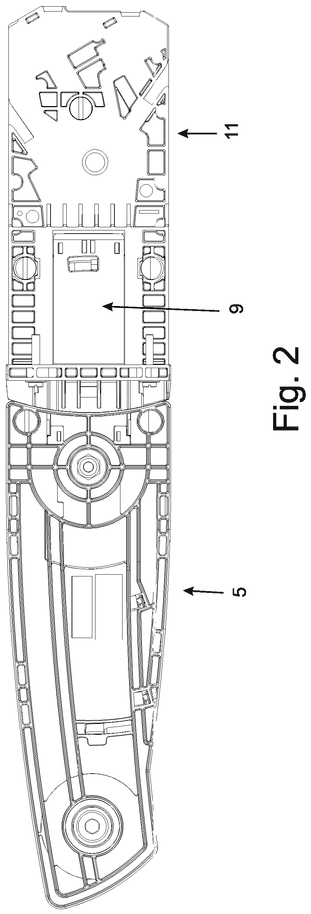

Fig. 2 zeigt ein Befestigungsteil 5 eines Prüfsteckerblocks 1 im eingesteckten Zustand in eine Befestigungsklemme 11. Der Einsteckabschnitt 8 des Befestigungsteils 5 ist im dargestellten Ausführungsbeispiel vollständig in den Aufnahmeabschnitt 9 der Befestigungsklemme 11 eingesteckt. Das System aus Befestigungsteil 5 und Befestigungsklemme 11 befindet sich ein einem ersten Verriegelungszustand, d.h. ein Herausziehen des Prüfsteckerblocks 1 ohne Weiteres ist nicht möglich.

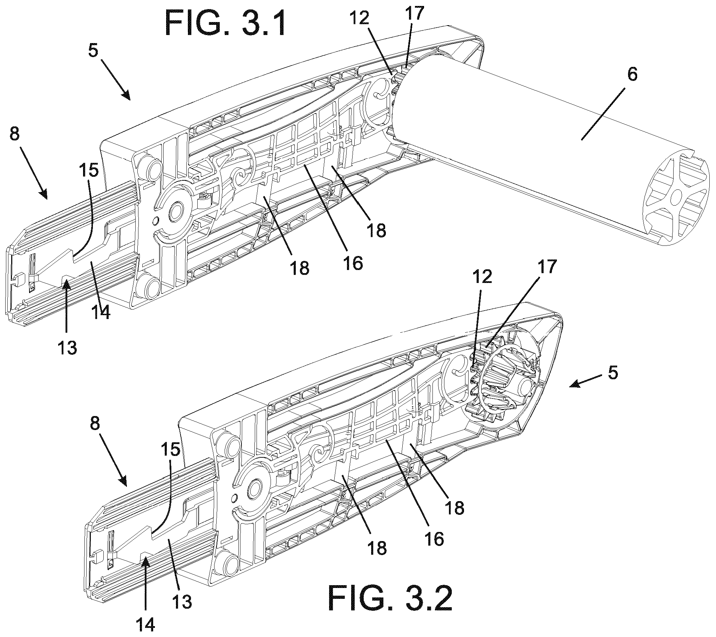

Fig. 3.1 zeigt ein Ausführungsbeispiel eines Befestigungsteils 5 zusammen mit einem Griffstück 6. Im Einsteckabschnitt 8 des Befestigungsteiles 5 ist ein Verriegelungselement 13 angeordnet, das durch eine Drehbewegung des Griffstückes 6 von einer Grundposition in eine Entriegelungsposition verbringbar ist. Dargestellt ist die Grundposition des Verriegelungselementes 13. Zur Realisierung einer Verriegelung zwischen dem Prüfsteckerblock 1 und dem Reihenklemmenblock 2 weist das Verriegelungselement 13 ein erstes Verbindungselement in Form eines Verriegelungshakens 14 auf, der mit einem korrespondierenden Verriegelungsvorsprung 21 im Klemmengehäuse 10 der Befestigungsklemme 11 zusammen eine erste Verriegelungsposition festlegt. Weiterhin weist das Verriegelungselement 13 eine Anschlagfläche 15 auf, die zusammen mit einer Gegenanschlagfläche 22 im Klemmengehäuse 10 der Befestigungsklemme 11 in der Entriegelungsposition des Verriegelungselementes 13 ein Herausziehen des Prüfsteckerblockes 1 verhindert und insofern eine zweite Verriegelungsposition festlegt.

Das Verriegelungselement 13 ist mit einem Hebelelement 16 verbunden, wobei das Hebelelement 16 wiederum über ein Zahnrad 17 mit dem Griffstück 6 in Verbindung steht. Dazu weist das Hebelelement 16 eine Mehrzahl von Zähnen 12 auf, die mit den Zähnen des Zahnrades 17 in Eingriff stehen.

Eine Drehung des Griffstücks 6 bewirkt eine Drehung des Zahnrades 17, wodurch das Hebelelement 16 im dargestellten Ausführungsbeispiel nach unten bewegt wird. Das Hebelelement 16 und das Verriegelungselement 13 sind derart miteinander verbunden, dass die Bewegung des Hebelelementes 16 auf das Verriegelungselement 13 übertragen wird, sodass das Verriegelungselement 13 von der Grundposition in die Entriegelungsposition verbringbar ist.

Des Weiteren sind im dargestellten Ausführungsbeispiel Federelemente 18 vorhanden, die das Hebelelement 16 in die dargestellte Grundposition des Hebelelementes 16 drücken.

In Fig. 3.2 ist das in Fig.3.1 dargestellte Ausführungsbeispiel des Befestigungsteils 5 ohne das Griffstück 6 gezeigt.

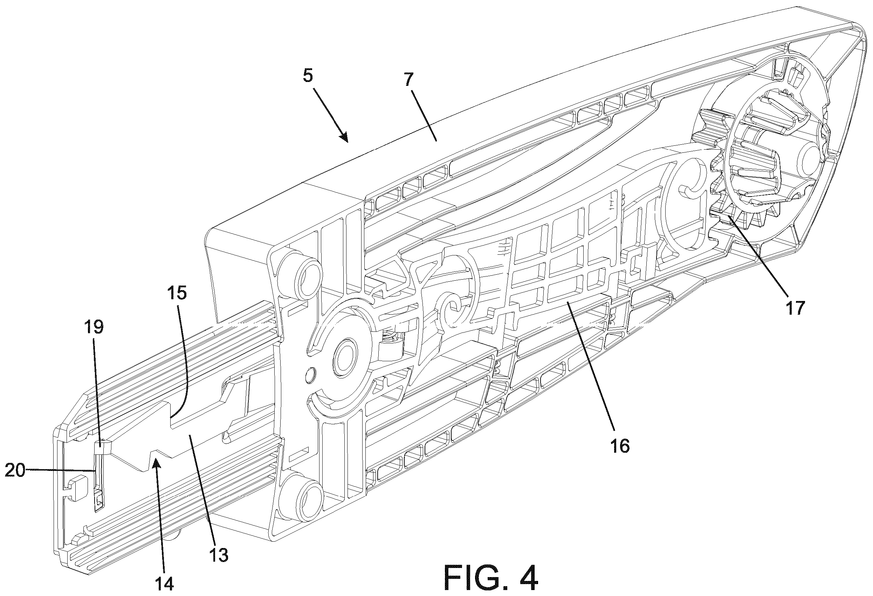

Fig. 4 zeigt ein Ausführungsbeispiel eines Befestigungsteils 5 in einem Zustand, in dem das Hebelelement 16 durch eine Drehung des Zahnrades 17 durch das nicht dargestellte Griffstück 6 derart ausgelenkt ist, dass sich das Verriegelungselement 13 in der Entriegelungsposition befindet.

Das dargestellte Verriegelungselement 13 weist an der dem Gehäuse 7 abgewandten Seite einen Führungsvorsprung 19 auf. Weiterhin weist der Einsteckabschnitt 8 eine Führungsfläche 20 in Form einer Nut auf, wobei der Führungsvorsprung 19 bewegbar in der Führungsfläche 20 angeordnet ist. Diese Anordnung begrenzt die Bewegung des Verriegelungselementes 13 auf den Bereich zwischen der Grundposition und der Entriegelungsposition, wobei der Anschlag des Führungsvorsprungs 19 an der unteren Kante der Führungsfläche 20 der Grundposition des Verriegelungselementes 13 entspricht und wobei der Anschlag des Führungsvorsprungs 19 an der oberen Kante der Führungsfläche der Entriegelungsposition des Verriegelungselementes 13 entspricht.

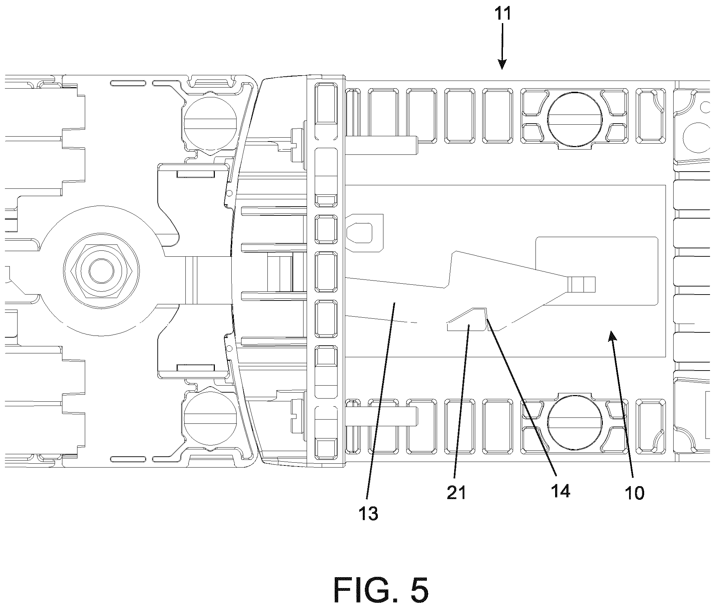

Die nachfolgenden Fig. 5 bis 8 zeigen die einzelnen Schritte bzw. Zustände im Verlauf eines Entriegelungsvorgangs.

Fig. 5 zeigt ein Ausführungsbeispiel eines Verriegelungselementes 13 in der der Grundposition. Das Verriegelungselement 13 weist einen Verriegelungshaken 14 auf, der mit dem Verriegelungsvorsprung 21 im Klemmengehäuse 10 der Befestigungsklemme 11 eine erste Verriegelungsposition festlegt. Dieser Zustand entspricht der Situation, dass der Prüfsteckerblock 1 in den Reihenklemmenblock voll eingesteckt ist.

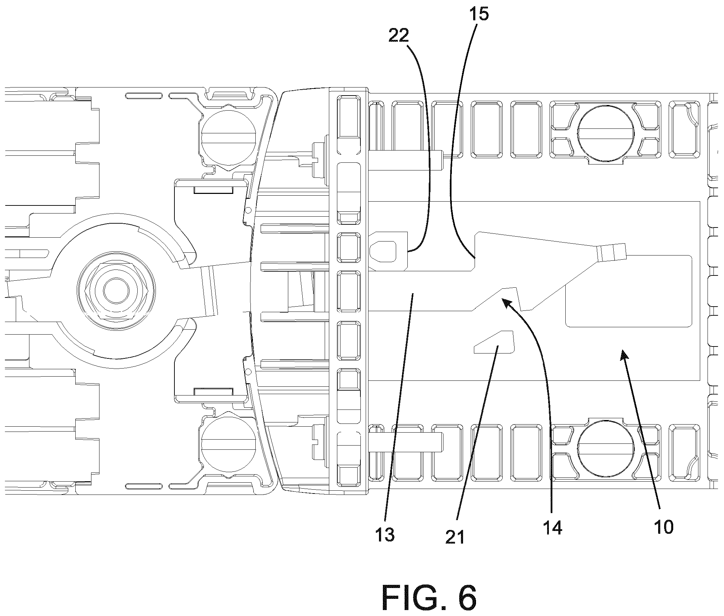

Zum Lösen dieser ersten Verriegelungsposition wird das Verriegelungselement 13 durch eine Drehbewegung des Griffstücks 6 in eine Entriegelungsposition, wie in Fig. 6 dargestellt, verbracht. In dieser Entriegelungsposition steht der Verriegelungshaken 14 nicht mehr mit dem Verriegelungsvorsprung 21 in Wirkzusammenhang. Nun ist es möglich, den Prüfsteckerblock 1 bis zum Anschlag der Anschlagfläche 15 des Verriegelungselementes 13 an der Gegenanschlagfläche 22 im Klemmengehäuse 10 der Befestigungsklemme 11 herauszuziehen.

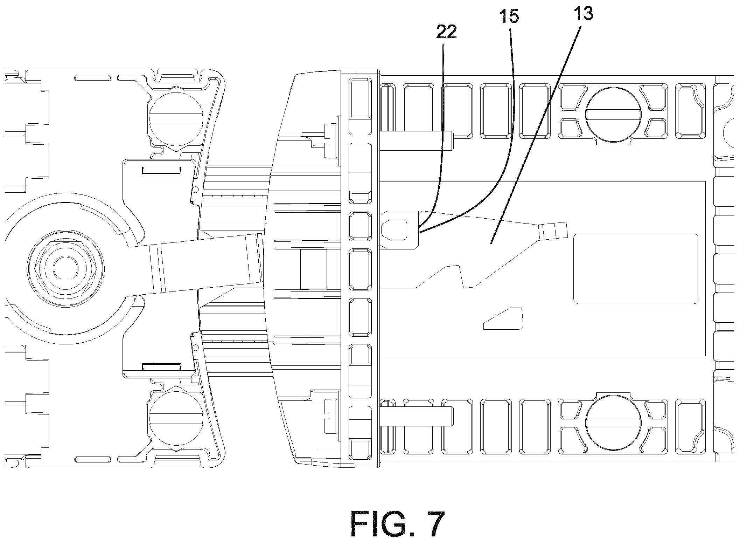

Dies ist in Fig. 7 dargestellt. Der Anschlag der Anschlagfläche 15 an der Gegenanschlagfläche 22 bewirkt eine zweite Verriegelungsposition, in der ein Herausziehen des Prüfsteckerblocks 1 ohne Weiteres nicht möglich ist.

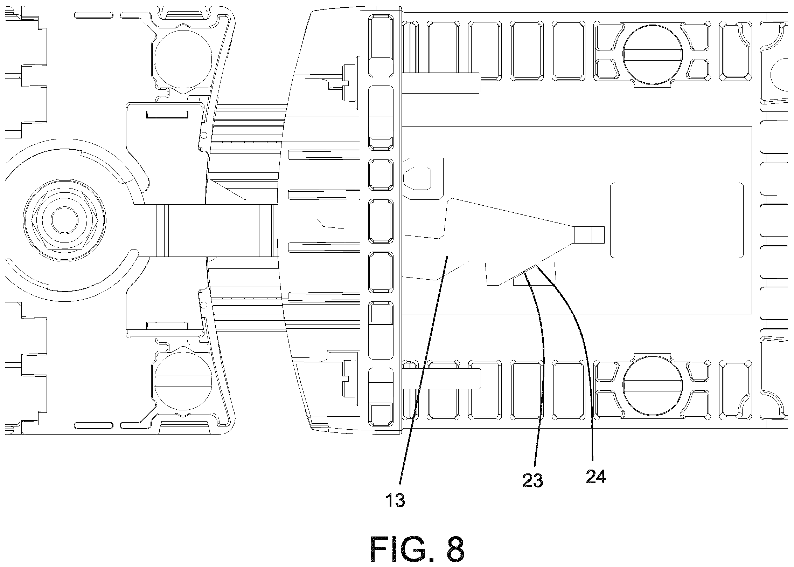

Zum Lösen der zweiten Verriegelungsposition wird das Verriegelungselement 13 nun erneut in die Grundposition verbracht, wodurch ein Zusammenwirken der Anschlagfläche 15 mit der Gegenanschlagfläche 22 aufgehoben wird. Dies ist in Fig. 8 dargestellt. Weiterhin zeigt Fig. 8, dass das Verriegelungselement 13 eine weitere Anschlagfläche 23 aufweist, die zusammen mit einer weiteren Gegenanschlagfläche 24 im Klemmengehäuse 10 der Befestigungsklemme 11 gewährleistet, dass die Bewegung des Verriegelungselementes 13 nicht über die Grundposition hinausgeht. Im dargestellten Ausführungsbeispiel wird die weitere Anschlagfläche 24 durch den Verriegelungsvorsprung 21 realisiert. Ein vollständiges Herausziehen des Prüfsteckerblocks 1 ist nun möglich.

Weiterhin sind im dargestellten Ausführungsbeispiel sowohl die Anschlagfläche 23 als auch die Gegenanschlagfläche 24 in Hinsicht auf den gegenteiligen Vorgang des Einsteckens des Prüfersteckerblocks 1 als Anlaufschrägen ausgestaltet, über die das Verriegelungselement 13 mit dem Einsteckvorgang in die erste Verriegelungsposition verbracht werden kann. In der dargestellten Ausgestaltung umfasst das zweite Verbindungselement in Form des Verriegelungsvorsprungs 21 damit sowohl eine Gegenanschlagfläche 24 zur Begrenzung der Bewegung des Verriegelungselementes 13 als auch ein zweites Lenkungselement in Form einer Anlaufschräge, wobei vorliegend die Gegenanschlagfläche 24 als Anlaufschräge ausgestaltet ist. Gleiches gilt für die Ausgestaltung der Anschlagfläche 23 des Verriegelungselementes 13 als Anlaufschräge.

Ein Einstecken des Prüfsteckerblocks 1 in den Reihenklemmenblock 2 kann damit in der Grundposition des Verriegelungselementes 13 erfolgen. Ist die Verbindung zwischen dem Hebelelement 16 und dem Verriegelungselement 13 weiterhin derart ausgestaltet, dass das Verriegelungselement 13 einen Bewegungsspielraum aufweist, findet keine Übertragung der Bewegung des Verriegelungselementes 13 auf das Hebelelement 16 und damit auch keine Übertragung auf das Griffstück 6 während des Einsteckens statt.

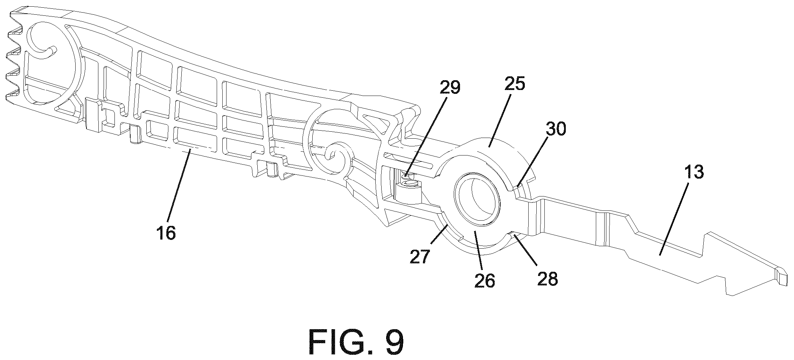

Fig. 9 zeigt ein Ausführungsbeispiel einer Verbindung von einem Hebelelement 16 mit einem Verriegelungselement 13. Das Hebelelement 16 weist einen rotationssymmetrischen kreisförmigen Aufnahmebereich 25 auf, in dem der rotationssymmetrische kreisförmige Anbindungsbereich 26 des Verriegelungselements 13 angeordnet ist. Der Anbindungsbereich 26 des Verriegelungselementes 13 wird in dem Aufnahmebereich 25 des Hebelelementes 16 mittels Rastnasen 27 gehalten. Der kreisförmige Anbindungsbereich 26 ist derart in dem kreisförmigen Aufnahmebereich 25 angeordnet, dass die beiden Bereiche 25, 26 eine gemeinsame Rotationsachse aufweisen. Im Ergebnis sind das Hebelelement 16 und das Verriegelungselement 13 damit drehbar zueinander angeordnet, sodass auch eine Bewegung des Verriegelungselementes 13 unabhängig von dem Hebelelement 16 realisiert werden kann.

Des Weiteren weist das Hebelelement 16 im Aufnahmebereich 25 ein Führungselement 28 auf, wobei das Führungselement 28 derart in Wirkzusammenhang mit dem Verriegelungselement 13 steht, dass das Verriegelungselement 13 bei einer Bewegung des Hebelelementes 16 durch Drehung des Griffstückes 6 durch das Führungselement 28 von der Grundposition in die Entriegelungsposition verbringbar ist. Im dargestellten Ausführungsbeispiel ist das Führungselement 28 als Anschlag ausgebildet.

Zur Gewährleistung, dass das Verriegelungselement 13 nach Krafteinwirkung stets in die Grundposition zurückgebracht wird, ist ein Federelement 29 zwischen dem Verriegelungselement 13 und dem Hebelelement 16 angeordnet. Im dargestellten Ausführungsbeispiel ist das Federelement 29 als Druckfeder ausgestaltet, die das Verriegelungselement 13 in die Grundposition drückt.

Darüber hinaus sind das Verriegelungselement 13 und das Hebelelement 16 wie bereits dargelegt, derart miteinander verbunden, dass das Verriegelungselement 13 einen gewissen Bewegungsspielraum aufweist. Dies hat den Vorteil, dass während des Einsteckens des Prüfsteckerblockes 1 in den Reihenklemmenblock 2 eine Bewegung des Verriegelungselementes 13 nicht auf das Hebelelement 16 und insofern nicht auf das Griffstück 6 übertragen wird.

Zur Begrenzung des Bewegungsspielraums weist der Aufnahmebereich 25 des Hebelelementes 16 ein Begrenzungselement 30 auf. Im dargestellten Ausführungsbeispiel ist das Begrenzungselement 30 als Anschlagfläche ausgestaltet. An der anderen Seite wird die Bewegung des Verriegelungselementes 13 durch das Führungselement 28 begrenzt.

Die dargestellten Ausführungsbeispiele des Prüfsteckerblockes 1 bzw. des Prüfklemmenblockes 3 weisen insgesamt den Vorteil auf, dass ein Einstecken des Prüfsteckerblockes 1 in den Reihenklemmenblock 2 bis zu einer ersten Verriegelungsposition der beiden Bauteile sowie ein mehrstufiges Herausziehen des Prüfsteckerblockes 1 aus dem Reihenklemmenblock 2 besonders einfach durch eine einzige Drehung des Griffstückes 6 erfolgen kann. Dabei erfolgt eine vollständige Entriegelung des eingesteckten Prüfsteckerblockes 1 durch folgende Bewegungsabfolge: Verbringen des Verriegelungselementes 13 von der Grundposition in die Entriegelungsposition durch Drehen des Griffstückes 6, Herausziehen des Prüfsteckerblockes 1 bis zum Anschlag der Anschlagfläche 15 an die Gegenanschlagfläche 22 (zweite Verriegelungsposition), Verbringen des Verriegelungselementes 13 von der Entriegelungsposition in die Grundposition, Herausziehen des Prüfsteckerblockes 1.

### Bezugszeichen

- 1: Prüfsteckerblock
- 2: Reihenklemmenblock
- 3: Prüfklemmenblock
- 4: Prüfstecker
- 5: Befestigungsteil
- 6: Griffstück
- 7: Gehäuse
- 8: Einsteckabschnitt
- 9: Aufnahmeabschnitt
- 10: Klemmengehäuse
- 11: Befestigungsklemme
- 12: Zähne des Hebelementes
- 13: Verriegelungselement
- 14: Verriegelungshaken
- 15: Anschlagfläche
- 16: Hebelelement
- 17: Zahnrad
- 18: Federelement
- 19: Führungsvorsprung
- 20: Führungsfläche
- 21: Verriegelungsvorsprung
- 22: Gegenanschlagfläche
- 23: Anschlagfläche
- 24: Gegenanschlagfläche
- 25: Aufnahmebereich
- 26: Anbindungsbereich
- 27: Rastnasen
- 28: Führungselement
- 29: Federelement
- 30: Begrenzungselement

## Patentansprüche

1. Prüfsteckerblock (1) zum Aufstecken auf einen Reihenklemmenblock (2), mit einer Mehrzahl von miteinander verbundenen Prüfsteckern (4) und zwei auf beiden Seiten der Mehrzahl von Prüfsteckern (4) angeordneten Befestigungsteilen (5), die über ein Griffstück (6) miteinander verbunden sind, wobei die Befestigungsteile (5) jeweils ein Gehäuse (7) und einen Einsteckabschnitt (8) aufweisen, der in einen Aufnahmeabschnitt (9) einsteckbar ist, wobei der Aufnahmeabschnitt (9) im Klemmengehäuse (10) einer Befestigungsklemme (11) des Reihenklemmenblocks (2) ausgebildet ist,
**dadurch gekennzeichnet,**
**dass** im Einsteckabschnitt (8) mindestens eines Befestigungsteils (5) ein Verriegelungselement (13) angeordnet ist,
**dass** das Verriegelungselement (13) durch eine Drehbewegung des Griffstückes (6) von einer Grundposition in eine Entriegelungsposition verbringbar ist,
**dass** das Verriegelungselement also zwischen zwei Positionen, nämlich der Grundposition und der Entriegelungsposition verstellbar ist,
**dass** das Verriegelungselement (13) ein erstes Verbindungselement in Form eines Verriegelungshakens (14) oder eines Verriegelungsvorsprungs aufweist, wobei das erste Verbindungselement mit einem korrespondierenden zweiten Verbindungselement in Form eines Verriegelungsvorsprungs (21) oder eines Verriegelungshakens im Klemmengehäuse (10) der mindestens einen Befestigungsklemme (11) zusammen eine erste Verriegelungsposition festlegt,
**dass** das Verriegelungselement (13) wenigstens eine Anschlagfläche (15) aufweist, und dass die Anschlagfläche (15) zusammen mit einer Gegenanschlagfläche (22) im Klemmengehäuse (10) der mindestens einen Befestigungsklemme (11) in der Entriegelungsposition des Verriegelungselementes (13) ein Herausziehen des Prüfsteckerblocks (1) verhindert.

2. Prüfsteckerblock (1) nach Anspruch 1, **dadurch gekennzeichnet, dass** das Verriegelungselement (13) wenigstens eine weitere Anschlagfläche (23) aufweist, die zusammen mit einer weiteren Gegenanschlagfläche (24) im Klemmengehäuse (10) der Befestigungsklemme (11) gewährleistet, dass die Bewegung des Verriegelungselementes (13) nicht über die Grundposition hinausgeht.

3. Prüfsteckerblock (1) nach einem der Ansprüche 1 oder 2, **dadurch gekennzeichnet, dass** das Verriegelungselement (13) an der dem Gehäuse (7) abgewandten Seite einen Führungsvorsprung (19) aufweist und dass der Einsteckabschnitt (8) eine Führungsfläche (20) aufweist, wobei der Führungsvorsprung (19) bewegbar in der Führungsfläche (20) angeordnet ist, sodass die Führungsfläche (20) die Bewegung des Verriegelungselementes (13) auf den Bereich zwischen der Grundposition und der Entriegelungsposition begrenzt und/oder das Verriegelungselement (13) mittels des Führungsvorsprungs (19) und der Führungsfläche (20) in Position gehalten wird.

4. Prüfsteckerblock (1) nach einem der Ansprüche 1 bis 3, **dadurch gekennzeichnet, dass** im Gehäuse (7) des mindestens einen Befestigungsteils (5) ein Hebelelement (16) angeordnet ist, wobei das Hebelelement (16) mit dem Verriegelungselement (13) verbunden ist und wobei das Verriegelungselement (13) durch eine Drehbewegung des Griffstücks (6) mittels des Hebelelementes (16) von der Grundposition in die Entriegelungsposition verbringbar ist.

5. Prüfsteckerblock (1) nach Anspruch 4, **dadurch gekennzeichnet, dass** das Hebelelement (16) und das Verriegelungselement (13) drehbar zueinander angeordnet sind und dass das Hebelelement (16) ein Führungselement (28) aufweist, wobei das Verriegelungselement (13) bei einer Bewegung des Hebelementes (16) durch Drehung des Griffstückes (6) durch das Führungselement (28) von der Grundposition in die Entriegelungsposition verbringbar ist.

6. Prüfsteckerblock (1) nach einem der Ansprüche 4 oder 5, **dadurch gekennzeichnet, dass** das Hebelement (16) einen rotationssymmetrischen Aufnahmebereich (25) aufweist, dass das Verriegelungselement (13) einen rotationssymmetrischen Anbindungsbereich (26), der in dem Aufnahmebereich (25) des Hebelementes (16) angeordnet ist, wobei der Anbindungsbereich (26) des Verriegelungselementes (13) in dem Aufnahmebereich (25) des Hebelelementes (16) vorzugsweise mittels wenigstens einer Rastnase (27) gehalten wird.

7. Prüfsteckerblock (1) nach einem der Ansprüche 4 bis 6, **dadurch gekennzeichnet, dass** ein Federelement (29) zwischen dem Verriegelungselement (13) und dem Hebelement (16) derart angeordnet ist, dass das Verriegelungselement (13) durch die Federkraft in die Grundposition verbracht wird, wenn das Griffstück (6) nicht betätigt ist und/oder der Prüfsteckerblock voll eingesteckt ist, sodass das Verriegelungselement (13) in der ersten Verriegelungsposition angeordnet ist.

8. Prüfsteckerblock (1) nach einem der Ansprüche 4 bis 7, **dadurch gekennzeichnet, dass** das Verriegelungselement (13) und das Hebelelement (16) derart miteinander verbunden sind, dass das Verriegelungselement (13) einen Bewegungsspielraum aufweist, sodass beim Einsteckvorgang des Prüfsteckerblocks (1) eine Bewegung des Verriegelungselementes (13) nicht auf das Hebelelement (16) übertragen wird.

9. Prüfsteckerblock (1) nach einem der Ansprüche 6 bis 8, **dadurch gekennzeichnet, dass** der Aufnahmebereich (25) wenigstens ein Begrenzungselement (30) aufweist, wobei das Begrenzungselement (30) die Bewegung des Verriegelungselementes (13) während des Einsteckvorgangs begrenzt.

10. Prüfsteckerblock (1) nach einem der Ansprüche 1 bis 9, **dadurch gekennzeichnet, dass** das Verriegelungselement (13) ein erstes Lenkungselement aufweist, das zusammen mit einem zweiten Lenkungselement im Klemmengehäuse (10) der mindestens einen Befestigungsklemme (11) das Verriegelungselement (13) beim Einsteckvorgang in die erste Verriegelungsposition führt.

11. Prüfsteckerblock (1) nach einem der Ansprüche 1 bis 10, **dadurch gekennzeichnet, dass** das erste Verbindungselement und die Anschlagfläche (15) in Längsrichtung und/oder quer zur Längsrichtung des Verriegelungselementes (13) versetzt zueinander angeordnet sind.

12. Prüfsteckerblock (1) nach einem der Ansprüche 1 bis 11, **dadurch gekennzeichnet, dass** im Gehäuse (7) des mindestens einen Befestigungsteils (5) mindestens ein Federelement (18) derart angeordnet ist, dass das Hebelelement (16) in seine Grundposition verbracht wird, wenn das Griffstück (6) nicht betätigt ist.

13. Prüfsteckerblock (1) nach einem der Ansprüche 1 bis 12, **dadurch gekennzeichnet, dass** das Griffstück (6) vorzugsweise über wenigstens ein Zahnrad (17) mit dem Hebelement (16) verbunden ist, wobei das wenigstens eine Zahnrad (17) mit einer Seite des Hebelelements (16) in Eingriff steht.

14. Prüfklemmenblock (3) bestehend aus einem Reihenklemmenblock (2) und einem auf den Reihenklemmenblock (2) aufsteckbaren Prüfsteckerblock (1), wobei der Reihenklemmenblock (2) eine Mehrzahl von nebeneinander angeordneten Reihenklemmen und auf beiden Seiten der Mehrzahl von Reihenklemmen je eine Befestigungsklemme (11) aufweist,
wobei der Prüfsteckerblock nach einem der Ansprüche 1 bis 13 ausgestaltet ist.

15. Verfahren zum Entriegeln eines Prüfklemmenblocks (3) nach Anspruch 14, **dadurch gekennzeichnet, dass** eine vollständige Entriegelung des eingesteckten Prüfsteckerblocks (1) durch folgende Bewegungsabfolge erfolgt: Verbringen des Verriegelungselementes (13) von der Grundposition in die Entriegelungsposition durch Drehen des Griffstückes (6), Herausziehen des Prüfsteckerblocks (1) bis zum Anschlag der Anschlagfläche (15) an die Gegenanschlagfläche (22), Verbringen des Verriegelungselementes (13) von der Entriegelungsposition in die Grundposition, Herausziehen des Prüfsteckerblocks (1).

## Claims

1. A test plug block (1) for mounting onto a series terminal block (2), comprising a plurality of interconnected test plugs (4) and two fastening parts (5) arranged on both sides of the plurality of test plugs (4), which are connected to one another via a grip piece (6), wherein the fastening parts (5) each comprise a housing (7) and an insertion section (8) that can be inserted into a receiving section (9), wherein the receiving section (9) is designed in the terminal housing (10) of a fastening clip (11) of the series terminal block (2),
**characterized in**
**that** a locking element (13) is arranged in the insertion section (8) of at least one fastening part (5),
**that** the locking element (13) can be moved from a rest position to an unlocked position by rotating the grip piece (6),
**that** the locking element is thus adjustable between two positions, namely the rest position and the unlocked position,
**that** the locking element (13) comprises a first connecting element in the form of a locking hook (14) or a locking projection, wherein the first connecting element, together with a corresponding second connecting element in the form of a locking projection (21) or a locking hook in the terminal housing (10) of the at least one fastening clip (11), defines a first locking position,
**that** the locking element (13) comprises at least one stop surface (15), and that the stop surface (15), together with a counter-stop surface (22) in the terminal housing (10) of the at least one fastening clip (11), prevents the test plug block (1) from being pulled out in the unlocked position of the locking element (13).

2. Test plug block (1) according to claim 1, **characterized in that** the locking element (13) comprises at least one additional stop surface (23) which, together with an additional counter-stop surface (24) in the terminal housing (10) of the fastening clip (11), ensures that the movement of the locking element (13) does not extend beyond the rest position.

3. Test plug block (1) according to any one of claims 1 or 2, **characterized in that** the locking element (13) has a guide projection (19) on the side facing away from the housing (7) and that the insertion section (8) has a guide surface (20), wherein the guide projection (19) is movably arranged in the guide surface (20) so that the guide surface (20) limits the movement of the locking element (13) to the range between the rest position and the unlocked position and/or the locking element (13) is held in position by means of the guide projection (19) and the guide surface (20).

4. Test plug block (1) according to any one of claims 1 to 3, **characterized in that** a lever element (16) is arranged in the housing (7) of the at least one fastening part (5), wherein the lever element (16) is arranged to be connected to the locking element (13) and wherein the locking element (13) can be moved from the rest position to the unlocked position by a rotational movement of the grip piece (6) via the lever element (16).

5. Test plug block (1) according to claim 4, **characterized in that** the lever element (16) and the locking element (13) are arranged so as to be rotatable relative to one another, and that the lever element (16) comprises a guide element (28), wherein the locking element (13) can be moved from the rest position to the unlocked position by the guide element (28) where the lever element (16) is moved by rotating the grip piece (6).

6. Test plug block (1) according to any one of claims 4 or 5, **characterized in that** the lever element (16) comprises a rotationally symmetrical receiving area (25), that the locking element (13) comprises a rotationally symmetrical fastening area (26) arranged in the receiving area (25) of the lever element (16), wherein the fastening area (26) of the locking element (13) in the receiving area (25) of the lever element (16) is preferably held by means of at least one latching catch (27).

7. Test plug block (1) according to any one of claims 4 to 6, **characterized in that** a spring element (29) is arranged between the locking element (13) and the lever element (16) such that the locking element (13) is moved into the rest position by the spring force when the grip piece (6) is not actuated and/or the test plug block is fully inserted, so that the locking element (13) is arranged in the first locking position.

8. Test plug block (1) according to any one of claims 4 to 7, **characterized in that** the locking element (13) and the lever element (16) are connected to one another such that the locking element (13) has a range of motion, so that during the insertion process of the test plug block (1), movement of the locking element (13) is not transmitted to the lever element (16).

9. Test plug block (1) according to any one of claims 6 to 8, **characterized in that** the receiving area (25) comprises at least one limiting element (30), wherein the limiting element (30) limits the movement of the locking element (13) during the insertion process.

10. Test plug block (1) according to any one of claims 1 to 9, **characterized in that** the locking element (13) comprises a first guide element which, together with a second guide element in the terminal housing (10) of the at least one fastening clip (11), guides the locking element (13) into the first locking position during the insertion process.

11. Test plug block (1) according to any one of claims 1 to 10, **characterized in that** the first connecting element and the stop surface (15) are arranged offset relative to one another in the longitudinal direction and/or transversely to the longitudinal direction of the locking element (13).

12. Test plug block (1) according to any one of claims 1 to 11, **characterized in that** at least one spring element (18) is arranged in the housing (7) of the at least one fastening part (5) such that the lever element (16) is moved into its rest position when the grip piece (6) is not actuated.

13. Test plug block (1) according to any one of claims 1 to 12, **characterized in that** the grip piece (6) is preferably connected to the lever element (16) via at least one gear (17), wherein the at least one gear (17) engages with one side of the lever element (16).

14. Test terminal block (3) comprising a terminal block (2) and a test plug block (1) that can be plugged onto the terminal block (2), wherein the terminal block (2) comprises a plurality of terminal blocks arranged side by side and, on both sides of the plurality of terminal blocks, one fastening clip (11) each,
wherein the test plug block is configured according to any one of claims 1 to 13.

15. Method for unlocking a test terminal block (3) according to claim 14, **characterized in that** complete unlocking of the inserted test plug block (1) is achieved by the following sequence of movements: moving the locking element (13) from the basic position to the unlocked position by rotating the grip piece (6), pulling out the test plug block (1) until the stop surface (15) abuts against the counter-stop surface (22), moving the locking element (13) from the unlocked position to the rest position, and pulling out the test plug block (1).

## Revendications

1. Bloc de fiches de test (1) destiné à être enfiché sur un bloc de bornes en série (2), comprenant une pluralité de fiches de test (4) reliées entre elles et deux parties de fixation (5) disposées de part et d'autre de la pluralité de fiches de test (4), qui sont reliées entre elles par une pièce de préhension (6), les parties de fixation (5) présentant chacun un boîtier (7) et une section d'insertion (8) apte à être insérée dans une section de réception (9), la section de réception (9) étant réalisée dans le boîtier de borne (10) d'une borne de fixation (11) du bloc de bornes en série (2), caractérisé en ce
dans la section d'insertion (8) d'au moins une partie de fixation (5), un élément de verrouillage (13) est disposé,
en ce que l'élément de verrouillage (13) peut être déplacé, par un mouvement de rotation de la pièce de préhension (6), d'une position de base vers une position de déverrouillage,
en ce que l'élément de verrouillage est ainsi réglable entre deux positions, à savoir la position de base et la position de déverrouillage,
en ce que l'élément de verrouillage (13) présente un premier élément de liaison sous la forme d'un crochet de verrouillage (14) ou d'une saillie de verrouillage, le premier élément de liaison définissant, avec un deuxième élément de liaison correspondant sous la forme d'une saillie de verrouillage (21) ou d'un crochet de verrouillage dans le boîtier de borne (10) de l'au moins une borne de fixation (11), une première position de verrouillage,
en ce que l'élément de verrouillage (13) présente au moins une surface de butée (15), et en ce que la surface de butée (15), conjointement avec une surface de contre-butée (22) dans le boîtier de borne (10) de l'au moins une borne de fixation (11), empêche, dans la position de déverrouillage de l'élément de verrouillage (13), un retrait du bloc de fiches de test (1).

2. Bloc de fiches de test (1) selon la revendication 1, **caractérisé en ce que** l'élément de verrouillage (13) présente au moins une autre surface de butée (23) qui, conjointement avec une autre surface de contre-butée (24) dans le boîtier de borne (10) de la borne de fixation (11), garantit que le mouvement de l'élément de verrouillage (13) ne dépasse pas la position de base.

3. Bloc de fiches de test (1) selon l'une quelconque des revendications 1 ou 2, **caractérisé en ce que** l'élément de verrouillage (13) présente, du côté opposé au boîtier (7), une saillie de guidage (19) et **en ce que** la section d'insertion (8) présente une surface de guidage (20), la saillie de guidage (19) étant disposée de manière mobile dans la surface de guidage (20), de sorte que la surface de guidage (20) limite le mouvement de l'élément de verrouillage (13) à la plage comprise entre la position de base et la position de déverrouillage et/ou que l'élément de verrouillage (13) est maintenu en position au moyen de la saillie de guidage (19) et de la surface de guidage (20).

4. Bloc de fiches de test (1) selon l'une quelconque des revendications 1 à 3, **caractérisé en ce qu'**un élément de levier (16) est disposé dans le boîtier (7) de l'au moins une partie de fixation (5), l'élément de levier (16) étant relié à l'élément de verrouillage (13) et l'élément de verrouillage (13) pouvant être déplacé, au moyen de l'élément de levier (16), d'une position de base vers une position de déverrouillage par un mouvement de rotation de la pièce de préhension (6).

5. Bloc de fiches de test (1) selon la revendication 4, **caractérisé en ce que** l'élément de levier (16) et l'élément de verrouillage (13) sont disposés de manière rotative l'un par rapport à l'autre et **en ce que** l'élément de levier (16) présente un élément de guidage (28), l'élément de verrouillage (13) pouvant être déplacé, lors d'un mouvement de l'élément de levier (16) par rotation de la pièce de préhension (6), de la position de base vers la position de déverrouillage par l'intermédiaire de l'élément de guidage (28).

6. Bloc de fiches de test (1) selon l'une quelconque des revendications 4 ou 5, **caractérisé en ce que** l'élément de levier (16) présente une zone de réception (25) à symétrie de rotation, **en ce que** l'élément de verrouillage (13) présente une zone de liaison (26) à symétrie de rotation disposée dans la zone de réception (25) de l'élément de levier (16), la zone de liaison (26) de l'élément de verrouillage (13) étant de préférence maintenue dans la zone de réception (25) de l'élément de levier (16) au moyen d'au moins un ergot d'encliquetage (27).

7. Bloc de fiches de test (1) selon l'une quelconque des revendications 4 à 6, **caractérisé en ce qu'**un élément de ressort (29) est disposé entre l'élément de verrouillage (13) et l'élément de levier (16) de telle sorte que l'élément de verrouillage (13) est déplacé, sous l'effet de la force de ressort, en position de base lorsque la pièce de préhension (6) n'est pas actionnée et/ou lorsque le bloc de fiches de test est entièrement enfiché, de sorte que l'élément de verrouillage (13) est disposé dans la première position de verrouillage.

8. Bloc de fiches de test (1) selon l'une quelconque des revendications 4 à 7, **caractérisé en ce que** l'élément de verrouillage (13) et l'élément de levier (16) sont reliés entre eux de telle sorte que l'élément de verrouillage (13) présente un jeu de mouvement, de sorte que, lors de l'opération d'insertion du bloc de fiches de test (1), un mouvement de l'élément de verrouillage (13) n'est pas transmis à l'élément de levier (16).

9. Bloc de fiches de test (1) selon l'une quelconque des revendications 6 à 8, **caractérisé en ce que** la zone de réception (25) présente au moins un élément de limitation (30), l'élément de limitation (30) limitant le mouvement de l'élément de verrouillage (13) pendant l'opération d'insertion.

10. Bloc de fiches de test (1) selon l'une quelconque des revendications 1 à 9, **caractérisé en ce que** l'élément de verrouillage (13) présente un premier élément de déviation qui, conjointement avec un deuxième élément de déviation dans le boîtier de borne (10) de la au moins une borne de fixation (11), guide l'élément de verrouillage (13) lors de l'opération d'insertion vers la première position de verrouillage.

11. Bloc de fiches de test (1) selon l'une quelconque des revendications 1 à 10, **caractérisé en ce que** le premier élément de liaison et la surface de butée (15) sont disposés de manière décalée l'un par rapport à l'autre dans la direction longitudinale et/ou transversalement à la direction longitudinale de l'élément de verrouillage (13).

12. Bloc de fiches de test (1) selon l'une quelconque des revendications 1 à 11, **caractérisé en ce qu'**au moins un élément de ressort (18) est disposé dans le boîtier (7) de l'au moins une partie de fixation (5) de telle sorte que l'élément de levier (16) est déplacé dans sa position de base lorsque la pièce de préhension (6) n'est pas actionnée.

13. Bloc de fiches de test (1) selon l'une quelconque des revendications 1 à 12, **caractérisé en ce que** la pièce de préhension (6) est de préférence reliée à l'élément de levier (16) au moyen d'au moins une roue dentée (17), l'au moins une roue dentée (17) étant en prise avec un côté de l'élément de levier (16).

14. Bloc de bornes de test (3) constitué par un bloc de bornes en série (2) et un bloc de fiches de test (1) pouvant être enfiché sur le bloc de bornes en série (2), le bloc de bornes en série (2) présentant une pluralité de bornes en série disposées côte à côte et, de part et d'autre de la pluralité de bornes en série, une borne de fixation (11), le bloc de fiches de test étant réalisé selon l'une quelconque des revendications 1 à 13.

15. Procédé de déverrouillage d'un bloc de bornes de test (3) selon la revendication 14, **caractérisé en ce qu'**un déverrouillage complet du bloc de fiches de test (1) enfiché est effectué selon la séquence de mouvements suivante : déplacement de l'élément de verrouillage (13) de la position de base vers la position de déverrouillage par rotation de la pièce de préhension (6), extraction du bloc de fiches de test (1) jusqu'à la mise en butée de la surface de butée (15) contre la surface de contre-butée (22), déplacement de l'élément de verrouillage (13) de la position de déverrouillage vers la position de base, extraction du bloc de fiches de test (1).
